# EUROPÄISCHE PATENTSCHRIFT

(11) **EP 0 312 751 B1**
(45) Veröffentlichungstag und Bekanntmachung des Hinweises auf die Patenterteilung: **15.02.1995**
(21) Anmeldenummer: 88114591.6
(22) Anmeldetag: 07.09.1988
(51) Int. Cl.: G03F 7/004

(54) **Positiv arbeitendes strahlungsempfindliches Gemisch und daraus hergestelltes strahlungsempfindliches Aufzeichnungsmaterial**
Positive-working radiation-sensitive composition and radiation-sensitive recording material produced therefrom
Composition sensible aux rayonnements à effet positif et matériel d'enregistrement sensible aux rayonnements produit de cette composition

(30) Priorität: 13.09.1987 DE 3730785
(43) Veröffentlichungstag der Anmeldung: 26.04.1989
(73) Patentinhaber: HOECHST AKTIENGESELLSCHAFT, 65926 Frankfurt am Main (DE)
(72) Erfinder: Dössel, Karl-Friedrich, Dr., D-6200 Wiesbaden (DE)

(56) Entgegenhaltungen:
- EP-A- 0 006 627
- EP-A- 0 031 566
- EP-A- 0 202 196
- FR-A- 2 305 757
- FR-A- 2 389 155

## Beschreibung

Die Erfindung betrifft ein positiv arbeitendes strahlungsempfindliches Gemisch enthaltend eine Verbindung, die unter Einwirkung von aktinischer Strahlung eine Säure bildet, sowie eine Verbindung, die durch Säure spaltbar ist.

Positiv arbeitende strahlungsempfindliche Gemische, bei denen durch Einwirkung von aktinischer Strahlung auf einen Photoinitiator eine Säure gebildet wird und diese dann in einer Sekundärreaktion ein säurespaltbares Material in den bestrahlten Bereichen in einem entsprechenden Entwickler löslich macht, sind seit langem bekannt.

Unter den bisher auf diesem Gebiet eingesetzten säurespaltbaren Materialien haben sich bewährt:
a) solche mit mindestens einer Orthocarbonsäureester-und/oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
b) Oligomer- oder Polymerverbindungen mit wiederkehrenden Acetal- und/oder Ketalgruppierungen in der Hauptkette,
c) Verbindungen mit mindestens einer Enolether- oder N-Acyliminocarbonatgruppierung,
d) Verbindungen mit Silylethergruppierungen,
e) Verbindungen mit Silylenolethergruppierungen und
f) cyclische Acetale oder Ketale von β-Ketoestern oder -amiden.

Durch Säure spaltbare Verbindungen des Typs a) als Komponenten strahlungsempfindlicher Gemische sind in der EP-A-0 022 571 und der DE-A-26 10 842 ausführlich beschrieben; Gemische, die Verbindungen des Typs b) enthalten, sind in der DE-C-23 06 248 und der DE-C-27 18 254 beschrieben; Verbindungen des Typs c) werden in den EP-A-0 006 626 und 0 006 627 genannt; Verbindungen, die dem Typ d) zuzurechnen sind, werden in den DE-A-35 44 165 und DE-A-36 01 264 vorgestellt, Verbindungen des Typs e) findet man in der gleichzeitig eingereichten Patentanmeldung P 37 30 783.5; Verbindungen vom Typ f), sind in der EP-A-0 202 196 erwähnt.

In der DE-A-26 10 842 werden Verbindungen mit Orthoester- oder -amidacetalgruppierungen in einer strahlungsempfindlichen Kopiermasse beschrieben, die ihre Anwendung sowohl in der Herstellung von Druckplatten als auch von mikroelektronischen Schaltungen finden. Untersuchungen haben gezeigt, daß die im Sub-1-»m-Bereich erforderlichen Auflösungen mit den dort geschilderten säurespaltbaren Verbindungen, die bei Belichtung Ameisensäureester geringerer Wasserlöslichkeit freisetzen, nicht oder nur bedingt erreicht werden können.

Auch die in der DE-A-27 18 254 beschriebenen strahlungsempfindlichen Kopiermassen sollen für lithographische Druckplatten wie auch für Positivresists eingesetzt werden. Sie enthalten als säurespaltbare Komponente eine (oligomere) Verbindung mit wiederkehrenden Acetal- oder Ketaleinheiten, deren Alkoholkomponente mindestens zweiwertig sein muß. Neben der durch den Herstellungsprozeß bedingten großen Schwankungsbreite der Molekulargewichte bzw. Polymerisationsgrade derartiger Polyacetale ist bei den säurespaltbaren Verbindungen die Gefahr des Eintrags von Verunreinigungen in das strahlungsempfindliche Gemisch besonders kritisch, weil eine destillative Reinigung nicht mehr möglich ist. Die beschriebenen Acetale und Ketale führen aufgrund der Auswahl der Aldehyd-bzw. Ketonkomponenten z. T. zu schwer entwickelbaren Gemischen bzw. lassen nur ein geringes Prozeßfenster zwischen Bestrahlung und Entwicklung, im allgemeinen zwischen 0,1 und 5 h, zu. In Abhängigkeit von dieser "Haltezeit" ergeben sich z. T. erhebliche Unterschiede in der Entwicklungsgeschwindigkeit, die so weit gehen können, daß eine Entwicklung überhaupt nicht mehr möglich ist.

In der Anwendung eines Aufzeichnungsmaterials, das ein solches säurespaltbares Material enthält, führt dies zu einer unakzeptablen Variation der Prozeßparameter. Darüber hinaus ist in den meisten Fällen die Strukturauflösung verbesserungswürdig; dies insbesonders, wenn das Acetal im Entwickler zu gut löslich ist, z.B. bei Acetalen mit 4-Hydroxybenzaldehyd als Aldehyd-Komponente.

Daneben wird in neuerer Zeit - abweichend vom bisherigen Stand der Technik - vorgeschlagen, cyclische Acetale oder Ketale von β-Ketoestern oder -amiden als säurespaltbares Material, das auch für die Anwendung in Photoresists geeignet sein soll, einzusetzen (EP-A-0 202 196). Ein Nachteil dieser Photoresists ist ihre geringe Strahlungsempfindlichkeit.

Es bestand daher die Aufgabe, ein positiv arbeitendes strahlungsempfindliches Gemisch bereitzustellen, das sich in möglichst reiner, einheitlicher Form herstellen läßt, das während unterschiedlicher "Haltezeiten" zwischen Bestrahlung und Entwicklung keine Änderungen hinsichtlich der Entwicklungszeit aufzeigt, d.h. einen größeren Verarbeitungsspielraum aufweist, die Anforderungen an eine hohe Strukturauflösung des entwickelten Resists erfüllt sowie eine einheitlich gute Entwickelbarkeit zeigt.

Gelöst wird die Aufgabe durch Bereitstellen eines positiv arbeitenden strahlungsempfindlichen Gemisches, enthaltend eine Verbindung, die unter Einwirkung von aktinischer Strahlung eine Säure bildet, sowie eine Verbindung, die durch Säure spaltbar ist, dadurch gekennzeichnet, daß die durch Säure spaltbare Verbindung monomer ist und eine Acetalgruppe enthält, deren Aldehyd- oder Ketonkomponente eine Entwicklerlöslichkeit von 0,1 bis 100 g/l und einen Siedepunkt über 150° C aufweist.

Die im erfindungsgemäßen strahlungsempfindlichen Gemisch enthaltenen monomeren Acetale haben den Vorteil, daß sie bei ihrer Herstellung besser zu reinigen sind und bei ihnen keine Probleme mit einer Polymerphasenunverträglichkeit mit anderen Polymeren im strahlungsempfindlichen Gemisch auftreten.

Die besondere Eignung der erfindungsgemäß eingesetzten monomeren Acetale ist auch dann gegeben, wenn anstelle eines polymeren Starters ein entsprechendes monomeres Material eingesetzt wird.

Der bevorzugte Siedepunkt der Aldehyd- bzw. Ketonkomponente im säurespaltbaren Material liegt bei 150° C bis 300° C, besonders bevorzugt bei 150 bis 270° C.

Die Löslichkeit der Hydrolyseprodukte des durch Säure spaltbaren Materials im Entwickler bezieht sich auf herkömmliche alkalische Entwickler sowohl des metallionenhaltigen als auch des metallionenfreien Typs (siehe Beispiel 1).

Während die Alkoholkomponente in den meisten Fällen unproblematisch im Entwickler in Lösung geht, ergeben sich für die Aldehyd- bzw. Ketonkomponenten erhebliche Unterschiede, so daß in der Regel die Löslichkeit dieser Komponenten für das Entwicklungsverhalten des bestrahlten Aufzeichnungsmaterials entscheidend ist.

Es hat sich gezeigt, daß gute Resultate sowohl im Hinblick auf die Entwicklungskinetik als auch hinsichtlich der Wiedergabequalität der Strukturen dann erzielt werden, wenn die Komponente des Acetals eine Entwicklerlöslichkeit zwischen 0,1 und 100 g/l aufweist.

Liegt die Löslichkeit unter 0,1 g/l, so werden schwer entwickelbare Schichten erhalten, deren Strukturauflösung schlecht ist und die zum "scumming" neigen. Ist die Entwicklerlöslichkeit zu hoch, so weisen die Schichten einen zu geringen Kontrast auf und feine Strukturen lassen sich nicht wiedergeben.

Die Löslichkeiten der Verbindungen im Entwickler lassen sich z. B. durch Eintragen eines Überschusses der Verbindung in den erwärmten Entwickler, Filtration nach dem Temperieren auf Raumtemperatur und anschließende Bestimmung des Feststoffs unter Berücksichtigung der bereits im Entwickler enthaltenen Festsubstanz bestimmen. Alternativ kann die Verbindung auch in einem entwicklermischbaren Lösungsmittel vorgelöst, die so erhaltene Lösung mit dem Entwickler gemischt und das Lösungsmittel zusammen mit der Entwicklerflüssigkeit zur Bestimmung der Festsubstanz entfernt werden. Zahlenwerte sind in den Beispielen angegeben.

Die Wahl der Alkoholkomponente der Schicht erweist sich als weniger kritisch, sofern sie monofunktionell ist. Grundsätzlich können alle Alkohole in Frage kommen, insbesondere diejenigen, die in der DE-A 26 10 842 genannt sind.

Der Gehalt des Acetals im erfindungsgemäßen strahlungsempfindlichen Gemisch beträgt 2 bis 30 Gew.-%, vorzugsweise 10 bis 25 Gew.-%, jeweils bezogen auf das Gesamtgewicht der Schichten.

Als Komponenten, die im erfindungsgemäßen strahlungsempfindlichen Gemisch beim Bestrahlen vorzugsweise eine starke Säure bilden bzw. abspalten, kommen eine große Anzahl von Verbindungen und Mischungen derselben in Frage.

Zu nennen sind Diazonium-, Phosphonium, Sulfonium- und Iodonium-Salze, Halogenverbindungen, o-Chinondiazidsulfochloride und -ester sowie Organometall-Organohalogen-Kombinationen.

Die genannten Diazonium-, Phosphonium-, Sulfonium- und Iodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure. U.a. werden diese Verbindungen auch in der DE-A-36 01 264 genannt.

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind. Diese können aber auch in Kombination mit anderen Photoinitiatoren wie Oxazolen, Oxadiazolen oder Thiazolen, aber auch untereinander in Mischungen eingesetzt werden.

Es sind aber auch Oxazole, Oxadiazole, Thiazol oder 2-Pyrone bekannt, die Trichlor- oder Tribrommethylgruppen enthalten (DE-A-30 21 599, 30 21 590, 28 51 472, 29 49 396 sowie EP-A-0 135 348 und 0 135 863).

Ebenso zählen unter diesen Oberbegriff insbesondere auch aromatische Verbindungen, die kernständiges Halogen, vorzugsweise Brom aufweisen. Solche Verbindungen sind aus der DE-A-26 10 842 bekannt oder werden in der gleichzeitig eingereichten Patentanmeldung P 37 30 784.3 beschrieben.

Als Vertreter einer Kombination mit einem Thiazol sei eine mit 2-Benzoylmethylen-naphtho[1,2-d]thiazol genannt (DE-A-28 51 641 und DE-A-29 34 758). Ein Gemisch einer Trihalogenmethylverbindung mit N-Phenylacridon ist aus der DE-A-26 10 842 bekannt.

Ebenso stehen α-Halogencarbonsäureamide (DE-A-27 18 200) oder Tribrommethyl-phenylsulfone (DE-A-35 03 113), die z.B. durch Benzophenon, Benzil oder Michlers Keton sensibilisiert werden können, zur Verfügung.

In der Regel können alle beschriebenen strahlungsempfindlichen Verbindungen durch Photosensibilisatoren in ihrer Effektivität unterstützt werden. Zu nennen sind z.B. Anthracen, Phenanthren, Pyren, 1,2-Benzanthren, Thiazine, Pyrazoline, Benzofurane, Benzophenone, Fluorenone, Anthrachinone sowie Cumarinderivate. Ihr Gehalt liegt bei 0,01 bis 5 Gew.-%, bezogen auf das Gewicht des strahlungsempfindlichen Gemisches.

Besonders bevorzugt sind vor allem Triazinderivate sowie aromatische Verbindungen mit kernständigem Halogen, insbesondere Brom, aus der DE-A-26 10 842 sowie der gleichzeitig eingereichten Patentanmeldung P 37 30 784.3.

Von den in dieser Anmeldung genannten Verbindungen sind solche bevorzugt, die einen pKₐ-Wert von 6 bis 10 aufweisen, ganz besonders diejenigen, die unter die allgemeine Formel I 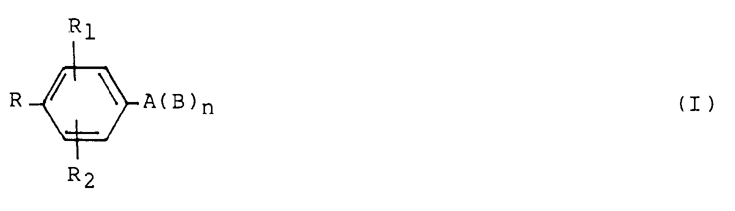
mit mindestens einem aromatisch gebundenen Chlor- oder Bromatom fallen, wobei
- R: Carboxyl, OR′ oder SR′,
- R₁, R₂: gleich oder verschieden sind und Wasserstoff, Chlor, Brom, Alkyl, ggf. substituiert durch Aryl-, Alkoxy-, Aryloxy-, Hydroxygruppen oder Fluoratome; Aryl, ggf. substituiert durch Alkoxy-, Aryloxy-, Hydroxygruppen oder Halogenatome,
- R′: Wasserstoff, Alkyl, ggf. substituiert durch Aryl-, Alkoxy-, Aryloxy-, Hydroxygruppen oder Fluoratome; Aryl, ggf. substituiert durch Alkoxy-, Aryloxy-, Hydroxygruppen oder Halogenatome; Acyl, Alkylsulfonyl, Arylsulfonyl, Alkoxycarbonyl, Triorganosilyl, Triorganostannyl oder eine Alkylen-, Arylen-, Bisacyl-, Sulfonyl-, Alkylendisulfonyl-, Arylendisulfonyl-, Diorganosilyl- oder Diorganostannylgruppe ist, deren zweite Valenz an das O-Atom einer weiteren Einheit der Formel I gebunden ist, wobei die Alkylen- und Arylengruppen entsprechend substituiert sein können wie die Alkyl- und Arylreste, und
- n: 0 bis 3

bedeuten, wobei
für n = 0:
- A: Wasserstoff, Chlor, Brom, Alkyl, ggf. substituiert durch Alkoxy-, Aryloxy-, Hydroxy-, Arylreste oder Fluoratome, Aryl, ggf. substituiert durch Alkoxy-, Aryloxy-, Hydroxy-, Carboxylreste oder Halogenatome,

für n = 1:
- A: eine Einfachbindung, -O-, -S-, -SO₂-, -NH-, -NR₃-, Alkylen, Perfluoralkylen,

für n = 2:
- A: -CR₃- oder 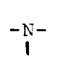 und

für n = 3:
- A: 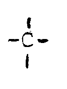 bedeutet,

sowie
- B: 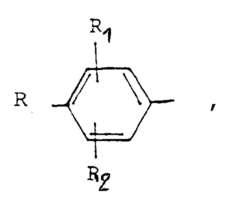 Carboxyl, substituiertes Carbonyl, insbesondere Alkyl- oder Arylcarbonyl, Carboxyalkyl sowie substituiertes Sulfonylimidocarbonyl und
- R₃: Alkyl, insbesondere (C₁-C₃)Alkyl, oder Aryl, insbesondere Phenyl,

bedeutet.

Diese Verbindungen werden vorzugsweise erst bei energiereicher, d.h. kürzerwelliger Strahlung gespalten. Hierunter zählt neben der UV-Strahlung vor allem die Elektronen- oder die Röntgenstrahlung.

Neben monomeren strahlungsempfindlichen Säurebildnern können auch Polymere dieser Art eingesetzt werden. Bei Verwendung von monomeren Startern liegt deren Gehalt im Bereich von 0,01 bis 30 Gew.-%, insbesondere von 0,4 bis 20 Gew.-%, bezogen auf das Gewicht der strahlungsempfindlichen Mischung.

Werden polymere Starter verwendet, so kann ggf. auf ein polymeres Bindemittel verzichtet werden. Darüber hinaus kann der polymere Starter mit dem Bindemittel gemischt sein; es ist aber auch möglich, daß die monomeren Bestandteile eines nicht polymerisierten Starters mit monomeren Bestandteilen des Bindemittels zu einem Mischkondensat oder -polymerisat reagieren. Dies hat zur Folge, daß dessen Gehalt in Abhängigkeit von seinem Anteil am Gehalt des Polymeren in dieser Mischung auch über den beschriebenen Bereich bei monomeren Startern hinausgehen kann. Insbesondere werden Gehalte von größer als 50 Gew.-% und bis zu 100 Gew.-%, abzüglich des Gehaltes der Verbindung, die durch Säure spaltbar ist, in Anspruch genommen.

Das erfindungsgemäße strahlungsempfindliche Gemisch enthält ferner ggf. ein in Wasser unlösliches, in organischem Lösemittel und Alkali aber lösliches, zumindest quellbares Bindemittel. Hierunter zählen vor allem Phenolharze vom Novolak-Typ. Genannt werden Phenol-Formal dehyd-Harze, Kresol-Formaldehydharze, deren Mischkondensate und deren Mischungen.

Daneben können auch Vinylpolymerisate wie Polyvinylacetale, Polymethacrylate, Polyacrylate, Polyvinylether, Polyvinylpyrrolidone sowie Styrolpolymerisate, jeweils ggf. durch Comonomere modifiziert, allein oder in Mischung mit anderen, eingesetzt werden.

Im besonderen sind zu nennen: Polymere von Styrol mit Einheiten von Alkenylsulfonyl-aminocarbonyloxy- oder Cycloalkenylsulfonylaminocarbonyloxy- (EP-A-0 184 804), Polymere der Acryl-, Methacryl-, Malein-, Itaconsäure etc. mit seitenständigen, vernetzenden -CH₂OR-Gruppen (EP-A-0 184 044), Polymerisate aus Vinylmonomeren mit Alkenylphenoleinheiten (EP-A-0 153 682), Polyvinylphenole als Novolakersatz (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)phosphinsäureiso(thio)cyanaten mit einem aktiven Wasserstoff enthaltenden Polymeren (deutsche Patentanmeldungen P 36 15 612.4 und P 36 15 613.2), Polymere mit Vinylacetat-, Vinylalkohol- und Vinylacetaleinheiten (EP-A-0 216 083) sowie Polyvinylacetale mit Einheiten aus Hydroxyaldehyden (deutsche Patentanmeldung P 36 44 162.7).

Die Menge des Bindemittels beträgt im allgemeinen 1 bis 90, insbesondere 5 bis 90 Gew.-%, vorzugsweise 50 bis 90 Gew.-%, bezogen auf das Gesamtgewicht der strahlungsempfindlichen Mischung.

Ferner können den erfindungsgemäßen strahlungsempfindlichen Gemischen ggf. Farbstoffe, Pigmente, Weichmacher, Netzmittel und Verlaufmittel, aber auch Polyglykole, Celluloseether, z.B. Ethylcellulose, zur Verbesserung spezieller Eigenschaften, wie Flexibilität, Haftung und Glanz, zugesetzt werden.

Vorzugsweise wird das erfindungsgemäße strahlungsempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatischen Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methylisobutylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran, und in Mischungen derselben gelöst. Besonders bevorzugt werden Glykolether, aliphatische Ester sowie Ketone.

Die mit den übrigen Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Substrat und dem darauf aufgetragenen strahlungsempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschichtetem Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, ggf. mit Aluminium beschichtete SiO₂-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilan-Typ, wie z.B. 3-Aminopropyl-triethoxysilan oder Hexamethyl-disilazan in Frage.

Beispiele für Träger, die zur Herstellung von photomechanischen Aufzeichnungsmaterialien wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/oder silikatierte Aluminiumplatten, Zinkplatten, Stahlplatten, die ggf. mit Chrom bearbeitet wurden, sowie Kunststoffolien oder Papier.

Das erfindungsgemäße Aufzeichnungsmaterial wird bildmäßig bestrahlt. Quellen der aktinischen Strahlung sind: Metallhalogenidlampen, Kohlebogenlampen, Xenonlampen und Quecksilberdampflampen. Bevorzugt wird eine Bestrahlung mit energiereicher Strahlung wie Laser, Elektronen- oder Röntgenstrahlung. Als Laser werden insbesondere Helium/Neon-Laser, Argon-Laser, Krypton-Laser sowie Helium/Cadmium-Laser genannt.

Die Beschichtungsmengen variieren in Abhängigkeit von ihrem Einsatzgebiet. Beim Aufbringen des strahlungsempfindlichen Gemisches z.B. auf eine Druckplatte wird die bevorzugte Beschichtungsmenge 0,5 bis 3,5 g/m² betragen. Im allgemeinen liegen die Schichtdicken zwischen 0,1 und 100 »m, insbesondere zwischen 1 und 10 »m.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuderbeschichten und Tauchbeschichten erfolgen. Danach wird das Lösungsmittel durch Verdampfen entfernt, so daß auf der Oberfläche des Substrates die strahlungsempfindliche Schicht zurückbleibt. Die Entfernung des Lösemittels kann gegebenfalls durch Erhitzen der Schicht auf Temperaturen von bis zu 150° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird.

Anschließend wird die Schicht bildmäßig bestrahlt. Üblicherweise wird aktinische Strahlung verwendet, besonders bevorzugt sind UV-, Röntgen- oder Elektronenstrahlung. Üblicherweise werden zur Bestrahlung UV-Lampen verwendet, die Strahlung einer Wellenlänge von 200 bis 500 nm mit einer Intensität von 0,5 bis 60 mW/cm² aussenden. In der strahlungsempfindlichen Schicht wird anschließend durch Entwicklung ein Bildmuster freigelegt, in dem die Schicht mit einer Entwicklerlösung behandelt wird, die die bestrahlten Bereiche des Materials löst bzw. entfernt.

Als Entwickler werden Lösungen von alkalischen Reagenzien wie z.B. Silikaten, Metasilikaten, Hydroxiden, Hydrogen- bzw. Dihydrogenphosphaten, Carbonaten bzw. Hydrogencarbonaten, insbesondere von Alkali- oder Ammoniumionen, aber auch Ammoniak, organische Ammoniumhydroxide und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Zur Erhöhung der Resistenz gegen mechanische und chemische Einflüsse, insbesondere gegen Ätzmedien, können die entwickelten Schichten noch einige Zeit, z.B. 5 bis 40 Minuten, auf erhöhte Temperatur, z.B. oberhalb 100° C, erhitzt werden, wobei diese Wirkung noch durch Belichten mit UV-Strahlung unterstützt werden kann.

Die Herstellung der in den erfindungsgemäßen strahlungsempfindlichen Gemischen enthaltenen Acetale kann durch Kondensation des Aldehyds bzw. Ketons mit dem Alkohol unter azeotroper destillativer Entfernung des Reaktionswassers erfolgen. Bei einer anderen bekannten Variante wird der Aldehyd bzw. das Keton mit Orthoameisensäuretrimethylester zum Dimethylacetal umgesetzt. In einer zweiten Stufe wird dieses dann mit einem Alkohol zum gewünschten Acetal zur Reaktion gebracht. Überraschend wurde bei den im folgenden beschriebenen Herstellungsmethoden gefunden, daß bei den beanspruchten Aldehyden bzw. Ketonen die gleichzeitige Zugabe von Orthoester und dem Alkohol nicht zu den hier unerwünschten Umesterungsprodukten des Orthoesters führte, sondern nur die gewünschten Acetale entstanden.

Anhand der folgenden Beispiele soll die Herstellung einer im erfindungsgemäßen strahlungsempfindlichen Gemisch enthaltenen neuen säurespaltbaren Verbindung verdeutlicht werden.

### Herstellungsbeispiel 1: Piperonal-dibutoxyethylacetal

Zu einer Mischung aus 1 mol Piperonal, 2 mol n-Butoxyethanol und 1,1 mol Orthoameisensäuretrimethylester wurden unter Kühlung 0,5 g p-Toluolsulfonsäure gegeben. Es wurde 2 h bei Raumtemperatur gerührt. Anschließend wurde an die Mischungsapparatur ein Wasserstrahlvakuum angelegt und jeweils 2 h bei 20° C, 40° C und 60° C weitergerührt. Abschließend wurde die Reaktionsmischung bei 80° C und einem Druck von 0,1 Torr über einen Dünnschichtverdampfer gegeben. Gegebenenfalls kann eine weitere Destillation im Dünnschichtverdampfer erfolgen, bei entsprechend erhöhter Temperatur.

Das resultierende Acetal wurde mit Na₂CO₃, K₂CO₃ oder basischem Aluminiumoxid verrührt, wodurch der saure Katalysator neutralisiert wurde. Die festen Bestandteile wurden abgetrennt und das Filtrat im Vakuum eingeengt. Das Acetal konnte in der nun vorliegenden Form in einem Aufzeichnungsmaterial eingesetzt werden. Es handelte sich um ein Öl mit einem Siedepunkt von 170 °C (0,01 Torr); im IR-Spektrum war kein CO-Signal erkennbar; das NMR-Spektrum (CDCl₃) zeigte ein Acetalsignal bei δ = 5,58 ppm.

### Herstellungsbeispiel 2: 4-Ethylbenzaldehyd-bis-(n-butoxyethoxyethyl)acetal

Es wurden 1 mol 4-Ethylbenzaldehyd, 2 mol n-Butoxyethoxyethanol entsprechend dem Herstellungsbeispiel 1 eingesetzt. Es konnte ein Acetal mit einem Siedepunkt von 175 °C (0,005 Torr) isoliert werden. Das NMR-Spektrum (CDCl₃) zeigte ein Signal für ein Acetal bei δ = 5,63 ppm.

### Herstellungsbeispiele H3 bis H6

Auf analoge Weise wurden folgende Acetale hergestellt:
- H3: Piperonal-bis- [2-(2-methoxy)ethoxyethyl]acetal
Kp > 170 °C (0,05 Torr), NMR-Spektrum (CDCl₃)
δ = 5,55 ppm (Acetal)
- H4: Benzaldehyd-dioctylacetal
Kp 148 °C (0,02 Torr), NMR-Spektrum (CDCl₃)
δ = 5,50 ppm (Acetal)
- H5: Terephthaldialdehyd-tetrakis-(n-butoxyethoxyethyl)acetal
NMR-Spektrum (CDCl₃) δ = 5,67 ppm (Acetal)
- H6: Thiophen-2-aldehyd-dimethoxyethylacetal
NMR-Spektrum (CDCl₃) δ = 5,85 ppm (Acetal)

Die folgenden Anwendungsbeispiele sollen die Erfindung näher erläutern; Mengen sind in Gewichtsteilen (Gt) angegeben.

### Beispiel 1

Es wurde eine Beschichtungslösung hergestellt aus
- 17 Gt: eines Kresol-Formaldehyd-Novolaks mit einem Erweichungsbereich von 105-120° C,
- 5 Gt: Piperonal-dibutoxyethylacetal (Herstellungsbeispiel 1, Siedepunkt von Piperonal 264 °C, Löslichkeit im Entwickler: 3,5 g/l) und
- 4 Gt: Tetrabrom-Bisphenol A (Dow Chemical) in
- 74 Gt: Propylenglykolmethyletheracetat.

Die Lösung wurde auf einem mit einem Haftvermittler (Hexamethyl-disilazan) behandelten Siliziumwafer bei 3.000 U/min aufgeschleudert. Nach der Trocknung bei 85° C für 30 min in einem Umluftofen wurde eine Schichtdicke von 1 »m erhalten. Bildmäßig bestrahlt wurde mit Synchrotron-Strahlung (BESSY, Berlin, 2 mm Luftspalt) einer Dosis von 32 mJ/cm² durch eine Gold-auf-Silicium-Maske. Den experimentellen Aufbau findet man bei A. Heuberger, "X-Ray Lithography", Microelectronic Engineering 3, 535-556 (1985). Nach einer Haltezeit von 5 min wurde 30 s mit einem alkalischen Entwickler der folgenden Zusammensetzung entwickelt:
5,3 Gt Natriummetasilikat x 9 H₂O,
3,4 Gt Trinatriumphosphat x 12 H₂O,
0,3 Gt Natriumdihydrogenphosphat und
91 Gt vollentsalztes Wasser.

Man erhielt ein fehlerfreies Bild mit allen Details der Maske, wobei auch Linien und Gräben von 0,3 »m fehlerfrei wiedergegeben wurden. Die Resistflanken waren nicht negativ unterhöhlt und zeigten Winkel von nahezu 90° (in einer Aufnahme eines Rasterelektronenmikroskops (REM)).

### Beispiel 2

Es wurden eine Beschichtungslösung und ein Resist entsprechend Beispiel 1 hergestellt; anstelle des dort angegebenen Acetals wurde allerdings Benzaldehyd-dioctylacetal (Herstellungsbeispiel 4) in gleicher Menge zugegeben (Siedepunkt von Benzaldehyd: 181° C; Löslichkeit im Entwickler 4 g/l). Die Ergebnisse hinsichtlich Auflösung und Winkel der Resistflanken zum Trägermaterial nach dem Entwickeln mit dem Entwickler aus Beispiel 1 waren mit denen aus Beispiel 1 vergleichbar.

### Beispiel 3

Es wurde eine Beschichtungslösung entsprechend Beispiel 1 hergestellt. Anstelle des dort angegebenen Acetals wurde Terephthaldialdehyd-tetrakis-(n-butyloxyethoxyethyl)acetal (Herstellungsbeispiel 5) eingesetzt (Siedepunkt von Terephthaldialdehyd: 245° C; Löslichkeit im Entwickler: 2 g/l). Nach Herstellung des Resists wurde dieser mit dem Entwickler gemäß Beispiel 1 entwickelt, wobei sich keine Unterschiede ergaben.

An zusätzlich in gleicher Weise hergestellten Siliciumwafern wurde der Einfluß der Haltezeit, der Zeit zwischen Bestrahlung und Entwicklung, auf die Ergebnisdaten untersucht. Bei Haltezeiten von 1, 4 und 12 h konnten aber keine Unterschiede in den Ergebnissen festgestellt werden.

### Beispiel 4 (Vergleichsbeispiel)

Anstelle des in Beispiel 1 eingesetzten Acetals wurde Hexanal-dibutoxyethylacetal in einer Beschichtungslösung, die sonst völlig der des Beispiels 1 entsprach, verwendet (Siedepunkt von Hexanal: 156° C, Löslichkeit des Aldehyds im Entwickler: < 0,1 g/l). Während die Entwicklungszeit 5 min nach der Bestrahlung bei 60 s lag, wurden bei einer Haltezeit von 2 h schon 90 s benötigt. Die Strukturauflösung dieser Probe war deutlich schlechter als in Beispiel 1.

### Beispiel 5

Es wurde eine Beschichtungslösung hergestellt, enthaltend
- 11 Gt: eines Kresol-Formaldehyd-Novolaks mit einem Erweichungsbereich von 105-120° C,
- 11 Gt: eines bromierten Poly-(p-hydroxy)styrols mit einem Bromgehalt von 50 Gew.-% und
- 5 Gt: p-Ethylbenzaldehyd-bis-(n-butoxyethoxyethyl)acetal (Herstellungsbeispiel 2) in
- 73 Gt: Propylenglykolmethyletheracetat.

Es wurde entsprechend Beispiel 1 beschichtet, bestrahlt und entwickelt. Es ergab sich ein Auflösungsvermögen und ein Verhalten der Resistflanken, die mit denen aus Beispiel 1 identisch waren.

### Beispiel 6

Es wurde eine Beschichtungslösung hergestellt, enthaltend
- 5 Gt: eines Poly(-brenzkatechin-monomethacrylates),
- 0,1 Gt: 2-(4-Ethoxy-naphth-1-yl)-4,6-bis-(trichlormethyl-s-triazin) und
- 1 Gt: Thiophen-2-aldehyd-dimethoxyethylacetal (Herstellungsbeispiel 6, Siedepunkt von Thiophen-2-aldehyd: 197° C) in
- 94 Gt: Butan-2-on.

Die Beschichtungslösung wurde in an sich bekannter Weise auf einen aus Aluminium bestehenden 0,3 mm dicken Druckplattenträger aufgetragen. Der Aluminiumträger war vorher elektrochemisch aufgerauht, anodisiert und mit Polyvinylphosphonsäure hydrophiliert worden. Nach dem Trocknen der Schicht wurde ein Schichtgewicht von 1,6 g/m² erhalten.

Die in dieser Weise hergestellte Offsetdruckplatte wurde mit einer Kopiervorlage bedeckt und mit Strahlung einer Quecksilberhochdrucklampe (5 kW) 20 s in einem Abstand von 110 cm bestrahlt. Mit einem Entwickler gemäß Beispiel 1 wurde entwickelt. Man erhielt eine positive Druckform mit hoher Auflösung, die in einer Offsetdruckmaschine 100.000 einwandfreie Drucke lieferte.

## Patentansprüche

1. Positiv arbeitendes strahlungsempfindliches Gemisch, enthaltend eine Verbindung, die unter Einwirkung von aktinischer Strahlung eine Säure bildet, sowie eine Verbindung, die durch Säure spaltbar ist, dadurch gekennzeichnet, daß die durch Säure spaltbare Verbindung monomer ist und eine Acetalgruppe enthält, deren Aldehyd- oder Ketonkomponente eine Entwicklerlöslichkeit von 0,1 bis 100 g/l und einen Siedepunkt über 150° C aufweist.

2. Strahlungsempfindliches Gemisch nach Anspruch 1, dadurch gekennzeichnet, daß das monomere Acetal ein Monoacetal ist.

3. Strahlungsempfindliches Gemisch nach einem der Ansprüche 1 oder 2, dadurch gekennzeichnet, daß das Gemisch ein in Wasser unlösliches, in wäßrig-alkalischen Lösungen aber lösliches Bindemittel enthält.

4. Positiv arbeitendes strahlungsempfindliches Aufzeichnungsmaterial, im wesentlichen bestehend aus einem Träger und einer strahlungsempfindlichen Schicht, dadurch gekennzeichnet, daß ein strahlungsempfindliches Gemisch gemäß den Ansprüchen 1 bis 3 verwendet wird.

5. Verfahren zur Herstellung eines positiv arbeitenden strahlungsempfindlichen Aufzeichnungsmaterials, dadurch gekennzeichnet, daß ein strahlungsempfindliches Gemisch gemäß den Ansprüchen 1 bis 3 auf einen ggf. mit einem Haftvermittler beaufschlagten Träger aufgetragen wird, das Material getrocknet, anschließend mit aktinischer Strahlung bildmäßig bestrahlt und abschließend das Bild durch Entwickeln mit einem wäßrig-alkalischen Entwickler freigelegt wird.

## Claims

1. A positive-working radiation-sensitive mixture containing a compound which forms an acid under the action of actinic radiation, and an acid-cleavable compound, wherein the acid-cleavable compound is monomeric and contains an acetal group whose aldehyde or ketone component has a developer solubility of 0.1 to 100 g/l and a boiling point above 150°C.

2. A radiation-sensitive mixture, as claimed in claim 1, wherein the monomeric acetal is a monoacetal.

3. A radiation-sensitive mixture as claimed in either of claims 1 and 2, wherein the mixture contains a binder which is insoluble in water, but soluble in aqueous alkaline solutions.

4. A positive-working radiation-sensitive recording material, essentially comprising a support and a radiation-sensitive layer, wherein a radiation-sensitive mixture as claimed in any of claims 1 to 3 is used.

5. A process for the production of a positive-working radiation-sensitive recording material, wherein a radiation-sensitive mixture as claimed in any of claims 1 to 3 is applied to a support, which is optionally coated with an adhesion promoter, the material is dried and subsequently irradiated imagewise with actinic radiation, and the image is subsequently bared by developing using an aqueous alkaline developer.

## Revendications

1. Composition photosensible travaillant en positif contenant un composé qui forme un acide sous l'action d'un rayonnement actinique, ainsi qu'un composé qui est clivé par un acide, caractérisée en ce que, le composé clivable par un acide est un monomère et contient un groupe acétal dont la composante aldéhydique ou cétonique présente une solubilité dans le révélateur comprise entre 0,1 et 100 g/l et un point d'ébullition supérieur à 150°C.

2. Composition photosensible selon la revendication 1, caractérisée en ce que l'acétal monomère est un mono-acétal.

3. Composition photosensible selon la revendication 1 ou la revendication 2, caractérisée en ce que la composition contient un liant insoluble dans l'eau mais soluble dans des solutions aqueuses alcalines.

4. Matériel de reproduction photosensible, travaillant en positif, essentiellement constitué d'un support et d'une couche photosensible, caractérisé en ce qu'une composition photosensible selon les revendications 1 à 3, est utilisée.

5. Procédé pour la préparation d'un matériel de reproduction photosensible, travaillant en positif, caractérisé en ce que l'on applique sur un support éventuellement revêtu d'un agent adhésif une composition photosensible, selon l'une des revendications 1 à 3, on sèche le matériel, on l'expose ensuite, selon l'image, à un rayonnement actinique et on met finalement à nu l'image par révélation dans un révélateur aqueux alcalin.
